(19) Europäisches Patentamt
European Patent Office
Office européen des brevets

(11) **EP 4 246 594 A1**

(12) **EUROPEAN PATENT APPLICATION**

(43) Date of publication:
**20.09.2023  Bulletin 2023/38**

(21) Application number: **23154694.6**

(22) Date of filing: **02.02.2023**

(51) International Patent Classification (IPC):
***H01L 29/778*** (2006.01)    ***H01L 29/36*** (2006.01)
***H01L 29/20*** (2006.01)

(52) Cooperative Patent Classification (CPC):
**H01L 29/7786; H01L 29/365;** H01L 29/2003;
H01L 29/7725

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **14.03.2022  TW 111109266**

(71) Applicant: **Ultraband Technologies Inc.
Zhubei City Hsinchu County 302058 (TW)**

(72) Inventor: **WU, Chan-Shin
302058 Hsinchu County (TW)**

(74) Representative: **2K Patentanwälte Blasberg
Kewitz & Reichel
Partnerschaft mbB
Schumannstrasse 27
60325 Frankfurt am Main (DE)**

(54) **SEMICONDUCTOR FIELD-EFFECT TRANSISTOR, POWER AMPLIFIER COMPRISING THE SAME AND MANUFACTURING METHOD THEREOF**

(57)    A semiconductor field-effect transistor contains an n-type doped layer (234) arranged close to the edge of the two-dimensional electron gas area (232G) in a channel layer (231); said n-type doped layer is arranged to adjust the distribution of electron concentration in the transistor, and to improve the RF linearity of the overall component; thereby not only the threshold voltage can be controlled through the adjustment of the charge, but the contact and series resistance can also be reduced.

FIG. 4

## Description

### FIELD OF TECHNOLOGY

The present invention is primarily related to semiconductor devices, but is not limited thereto. The present invention relates in particular to a semiconductor field-effect transistor, a power amplifier comprising the same, and a manufacturing method thereof.

### BACKGROUND

With the rapid development and popularization of wireless communication systems and mobile devices, the demand for radio frequency (RF) power components in the industry is gradually rising. Especially in the application market of 5G infrastructure, in order to reduce costs, improve efficiency and expand bandwidth, excellent RF components play an indispensable role.

Among semiconductor field-effect transistors, aluminum gallium nitride (AlGaN)/gallium nitride (GaN) high electron mobility transistors (HEMTs) have the advantages of low on-resistance, high electrical density and large collapse voltage, so they are regarded as popular technical options for RF power components. The above excellent properties are mainly attributed to the excellent material characteristics of GaN, such as wide bandgap, high critical electrical field and high electron saturation velocity. In addition, the unique polarization effect of GaN enables the AlGaN/GaN heterostructure to form two-dimensional electron gases (2DEG) by induction at the interface block without doping, thus enabling AlGaN/GaN HEMTs to operate with high current output and very low on-resistance.

On the other hand, the linearity of the power amplifier is also an important measure in the field of wireless communication. The improvement of linearity can reduce the intermodulation distortion between different frequency signals of power components, especially for the third-order intermodulation distortion, thus reducing the noise of communication system. It is found that if gentler/more uniform the distribution of transconductance ($g_m$) versus gate-source voltage ($V_{gs}$) of a component, or the lower the $\left(\dfrac{\partial^2 g_m}{\partial V_{gs}{}^2}\right)$, the better the linearity of the component.

### SUMMARY

It is an object of the present invention to provide a semiconductor field-effect transistor enabling in particular an enhanced linearity. Further aspects of the present invention relate to a power amplifier comprising such a semiconductor field-effect transistor, and a manufacturing method for manufacturing such a semiconductor field-effect transistor.

These problems are solved by a semiconductor field-effect transistor as claimed in claim 1, by a power amplifier as claimed in claim 9, and by a method for manufacturing a semiconductor field-effect transistor as claimed in claim 10. Further advantageous embodiments are the subject-matter of the dependent claims.

The brief description of the present invention are provided in order to give the reader a basic understanding of the present invention. The summary is not a complete overview of the present invention and is not intended to point out important or critical components of embodiments of the present invention or to define the scope of the present invention.

The inventors have found that conventional semiconductor field-effect transistors often exhibit prominent peaks of at least one period of $g_m$ within a specific range of $V_{gs}$ values, causing suspicion of poor linearity. The inventors have further discovered that the distribution of the electron concentration in the transistor in space is highly correlated with the distribution of $g_m$ relative to $V_{gs}$. The electrons in said transistor specifically refer to groups of electrons in the channel layer such as two-dimensional electron gases (2DEG) confined to a potential energy well; or doped channel formed by doping. According to the inventor, by adjusting the distribution of the electron group, the numerical distribution of the transconductance relative to the gate-source voltage of the component can be effectively adjusted, and the linearity of the module can be further improved. In view of this, the present invention provides a semiconductor field-effect transistor, wherein a channel layer of the semiconductor field-effect transistor is provided with an n-type doped layer; said n-type doped layer is arranged to adjust the distribution of electron concentration in the transistor, and to improve the RF linearity of the overall component. The semiconductor field-effect transistor manufactured accordingly can not only control the threshold voltage by adjusting the charge, but can also reduce the resistance.

In particular, one aspect of the present invention provides a semiconductor field-effect transistor, which includes a channel layer, a barrier layer, a gate, a source and a drain. The barrier layer is disposed on the channel layer, the channel layer and the barrier layer are made of different materials, and the channel layer is provided with a two-dimensional electron gas area near the barrier layer. The gate disposed on the barrier layer. The source and a drain are disposed near two ends of the gate, respectively. The channel layer further includes an n-type doped layer which is disposed at a boundary of the two-dimensional electron gas area.

According to an embodiment of the present invention, the n-type doped layer comprises a silicon dopant.

According to an embodiment of the present invention, the n-type doped layer has a sheet electron concentration between $1.5*10^{12}$ and $6*10^{12}$ ns*cm$^{-2}$; and the n-type doped layer includes a high concentration electron group with an electron concentration of $1.5*10^{19}$ to

$3*10^{19}$ ns*cm$^{-3}$. As regards the definition of the term 'sheet electron concentration', reference is made to Nisha Chugh, Monika Bhattacharya, Manoj Kumar and R.S Gupta, 'Sheet Carrier Concentration and Threshold Voltage Modeling of Asymmetrically Doped AlGaN/GaN/AlGaN Double Heterostructure HEMT', 2017 4th IEEE Uttar Pradesh Section International Conference on Electrical, Computer and Electronics (UPCON), GLA University, Mathura, Oct 26-28, 2017, p. 446 - 451, the whole content of which is hereby incorporated by reference. As regards the definition of the term 'electron concentration', reference is made to Bernard Gil, Chapter 6 - Stress Effects on Optical Properties, Volume 57, 1999, Pages 209-274, the whole content of which is hereby incorporated by reference.

According to an embodiment of the present invention, the n-type doped layer is separated from a junction of the channel layer and the barrier layer by 6 to 10 nm.

According to an embodiment of the present invention, the channel layer is formed by unintentionally doped or undoped GaN, and the barrier layer is formed by unintentionally doped or undoped AlGaN.

According to an embodiment of the present invention, the semiconductor field-effect transistor further includes a passivation layer disposed on the barrier layer, and the passivation layer covering at least part of upper surfaces of the source, the gate and the drain.

According to an embodiment of the present invention, the semiconductor field-effect transistor further includes a buffer layer disposed below the channel layer.

According to an embodiment of the present invention, the semiconductor field-effect transistor is a Modulation-Doped Field-Effect Transistor (MODFET) a High Electron Mobility Transistor (HEMT), a Metal-Oxide-Semiconductor Field-Effect Transistor (MOSFET), a Metal-Semiconductor Field-Effect Transistor (MESFET) or a Metal-Insulator-Semiconductor Field-Effect Transistor (MISFET).

Another aspect of the present invention provides a power amplifier, which includes the semiconductor field-effect transistor described above.

Yet another aspect of the present invention provides a method of manufacturing a semiconductor field-effect transistor, which includes: forming a buffer layer on a substrate; forming a channel layer on the buffer layer and forming an n-type doped layer in the channel layer; forming a barrier layer on the channel layer; and forming a gate on the barrier layer, and forming a source and a drain near two ends of the gate electrode, respectively.

According to an embodiment of the present invention, the n-type doped layer is formed by doping a silicon dopant.

According to an embodiment of the present invention, the n-type doped layer formed to has a sheet electron concentration between $1.5*10^{12}$ and $6*10^{12}$ ns*cm$^{-2}$; and the n-type doped layer includes a high concentration electron group with an electron concentration of $1.5*10^{19}$ to $3*10^{19}$ ns*cm$^{-3}$.

According to an embodiment of the present invention, the n-type doped layer is formed at a distance of 6 and 10 nm from a junction of the channel layer and the barrier layer.

Another aspect of the present invention provides a linear power amplifier including the semiconductor field-effect transistor according to the present invention.

The semiconductor field-effect transistor and the manufacturing method thereof provided by the present invention have the advantages that by virtue of the n-type doped layer arranged in the channel layer, the electron distribution in the transistor is changed concretely, such as the electron concentration distribution in the space around the two-dimensional electron gas, and the radio frequency linearity of the component is substantially improved; whereby not only the threshold voltage can be controlled through the adjustment of the charge, also the resistance can be reduced. Therefore, the present invention not only retains the original advantages of various semiconductor field-effect transistors, but also has outstanding linearity, thereby improving the potential value of the present invention in the field related to radio frequency power amplifiers.

## BRIEF DESCRIPTION OF THE DRAWINGS

In order to make the above and other objects, features, advantages and embodiments of the present invention more readily understood, the drawings are described as follows:

FIG. 1 is a cross-sectional view of a conventional semiconductor device;
FIGS. 2A to 2E are characteristic analysis diagrams according to the conventional semiconductor device;
FIGS. 3A to 3D are characteristic analysis diagrams according to an embodiment of the present invention;
FIGS. 4 to 7 are cross-sectional views of layers of the semiconductor device according to various embodiments of the present invention;
FIG. 8 is a flowchart of manufacturing a semiconductor field-effect transistor according to various embodiments of the present invention.

The various features and components in the drawings are not drawn to actual scale in accordance with the customary mode of operation, but are drawn in such a way as to best present the specific features and components associated with the present invention. In addition, similar components and parts are referred to by the same or similar reference signs in different figures.

## DESCRIPTION OF THE EMBODIMENTS

In order for the description of the present invention to be more exhaustive and complete, an illustrative description of embodiments and specific embodiments of the present invention is set forth below, but this is not the only form in which specific embodiments of the present invention are practiced or employed. In this description and the appended claims, unless the context otherwise requires, "a" and "the" may also be construed in the plural. In addition, in this description and the appended claims, unless otherwise stated, "disposed on something" can be regarded as direct or indirect contact with a surface of something by attachment or other form, and the definition of such surface should be judged according to the semantics before and after the content of the description and the common knowledge of the field to which the present invention belongs.

Although the numerical ranges and parameters used to define the present invention are approximate values, the relevant values in particular embodiments have been presented as precisely as possible. However, any numerical value inevitably contains standard deviation caused by individual test methods. In this context, "approximately" generally means that the actual value is within plus or minus 10%, 5%, 1% or 0.5% of a specific value or range. Alternatively, the word "approximately" means that the actual value falls within the acceptable standard error of the average value, which is the consideration of those having ordinary knowledge in the field to which the present invention belongs. Therefore, unless otherwise stated, the numerical parameters disclosed in this description and the scope of the accompanying claims are approximate values and may be varied as required. At least, these numerical parameters should be understood as the number of significant digits indicated and the values obtained by applying the general carry method.

The present invention relates to a semiconductor field-effect transistor and a manufacturing method thereof. The semiconductor field-effect transistor is preferably a compound semiconductor field-effect transistor. The semiconductor field-effect transistor is more preferably an aluminum gallium nitride (AlGaN)/gallium nitride (GaN) high electron mobility transistors (HEMTs). However, according to different embodiments, the semiconductor field-effect transistor may also be a Modulation-Doped Field-Effect Transistor (MODFET), a Metal-Oxide-Semiconductor Field-Effect Transistor (MOSFET), a Metal-Semiconductor Field-Effect Transistor (MESFET) or a Metal-Insulator-Semiconductor Field-Effect Transistor (MISFET). Specifically, the MOSFET herein may be an n-type or p-type silicon-based metal oxide semiconductor field-effect transistor (Si-MOSFET) or an n-type or p-type silicon carbide-based metal oxide semiconductor field-effect transistor (SiC-MOSFET). The semiconductor field-effect transistor may be a planar transistor or a non-planar transistor, such as a Fin Field-Effect Transistor (FinFET) or a Gate-All-Around Field-Effect Transistor (GAAFET) transistor. The semiconductor field-effect transistor includes a channel layer and a barrier layer, and the channel layer and the barrier layer are made of different materials, so that there is a heterogeneous junction between the channel layer and the barrier layer, and the block of the heterogeneous junction inductively forms two-dimensional electron gases (2DEG) region. Furthermore, the compound semiconductor field-effect transistor provided by the present invention is provided with an n-type material layer near the boundary of the two-dimensional electron gas area in the channel layer. The n-type material layer substantially changes the electron concentration distribution in the space around the two-dimensional electron gas, thereby improving the linearity of the component.

As used herein, the term " the boundary of the two-dimensional electron gas area" refers to the position in the channel layer where the electron concentration in the two-dimensional electron gas area approaches zero. Generally speaking, the distance between the boundary of the two-dimensional electron gas area and the junction of the channel layer and the barrier layer may vary depending on the material. According to the preferred embodiment of the present invention, the distance is 6 to 10 nm, for example: 6.0, 6.1, 6.2, 6.3, 6.4, 6.5, 6.6, 6.7, 6.8, 6.9, 7.0, 7.1, 7.2, 7.3, 7.4, 7.5, 7.6, 7.7, 7.8, 7.9, 8.0, 8.1, 8.2, 8.3, 8.4, 8.5, 8.6, 8.7, 8.8, 8.9, 9.0, 9.1, 9.2, 9.3, 9.4, 9.5, 9.6, 9.7, 9.8, 9.9 or 10.0 nm.

Specifically, the "high electron mobility transistor" of the present invention can be a normally ON structure with a negative threshold voltage. It can also be converted to a normally OFF structure with a positive threshold voltage. On the other hand, the "semiconductor material" of the present invention may include chemical compounds of a plurality of elements including, but not limited to, one or more elements of different families with GaN in the chemical periodic table. These chemical compounds may include a pair of elements of group 13 (i.e., the group containing boron (B), aluminum (Al), gallium (Ga), indium (In) and thallium (Tl)) and group 15 (i.e., the group containing nitrogen (N), phosphorus (P), arsenic (As), antimony (Sb) and bismuth (Bi)), or a pair of elements of group 14 (i.e., the group containing carbon (C), silicon (Si), germanium (Ge) and tin (Sn), such as silicon carbide (SiC) or silicon-germanium alloy. Groups 13 to 15 of the periodic table may be referred to as Groups III, IV and V, respectively.

Another aspect of the present invention relates to a method of manufacturing a semiconductor field-effect transistor. In general, the layers, doping, shielding, and device structures described herein are formed using any suitable technique (e.g., deposition, growth, patterning, or etching) for forming such layers, doping, shielding, and device structures.

In addition, the semiconductor field-effect transistor provided by the present invention can be arranged in a power amplifier.

## Embodiments

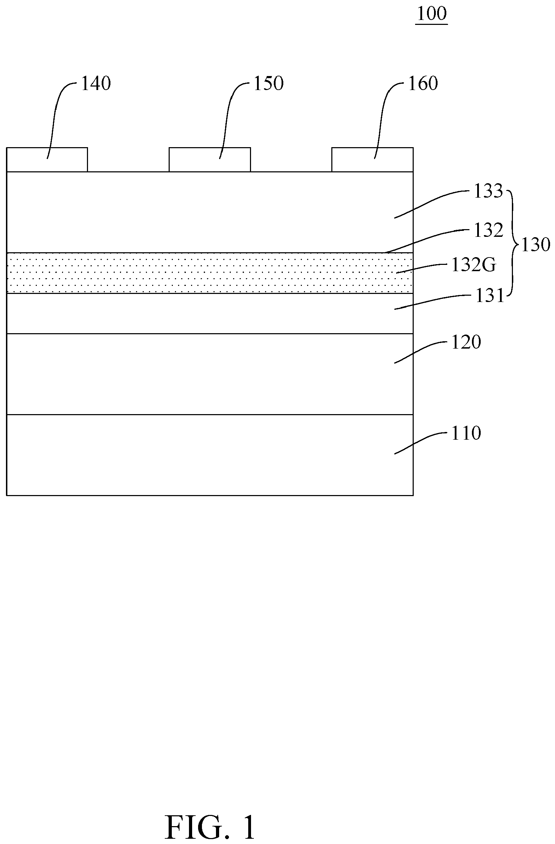

FIG. 1 is a cross-sectional view of layers depicted in accordance with a conventional semiconductor device 100. Referring to FIG. 1, the conventional semiconductor device 100 is essentially a semiconductor device based on an aluminum gallium nitride/gallium nitride high electron mobility transistor and is an epitaxial grown layered structure. The conventional semiconductor device 100 includes a substrate 110, a buffer layer 120, a channel block 130, a source electrode 140, a gate electrode 150, and a drain electrode 160.

The channel block 130 is disposed on a surface of the buffer layer 120 and further includes a channel layer 131 and a barrier layer 133. A junction 132 is formed between the channel layer 131 and the barrier layer 133, which is a heterogeneous material interface, so that a two-dimensional electron gas area 132G can be formed near the junction 132 in the channel layer 131. The two-dimensional electron gas area 132G can form a conductive channel of free electrons when biased, thereby achieving, for example, the purpose of electrically coupling the source electrode 140 and the drain electrode 160. Specifically, the compound semiconductor material of the channel layer 131 is undoped or unintentionally doped GaN, and the compound semiconductor material of the barrier layer 133 is undoped or unintentionally doped $Al_xGa_{1-x}N$, where x is in the range of about 0.1 to about 1.

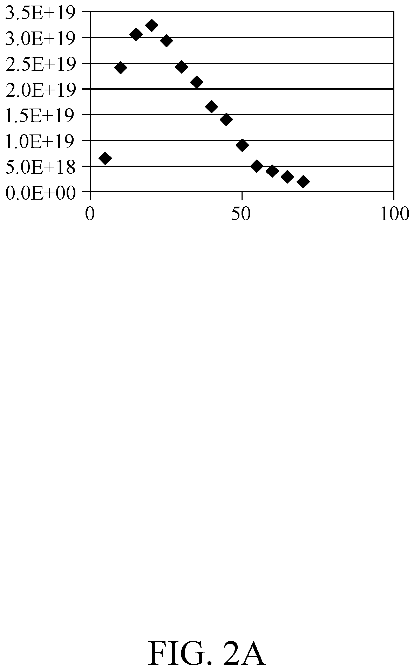

FIGS. 2A to 2D are analysis of the characteristics exhibited by the above-mentioned conventional semiconductor device 100. Please refer to FIGS. 1 to 2D together. FIG. 2A is a diagram showing the change of electron concentration relative to channel layer space according to the conventional semiconductor device 100. The longitudinal axis indicates the electron concentration ($ns*cm^{-3}$ or $cm^{-3}$), and the transverse axis indicates the distance (Å or $10^{-1}$ nm) from the junction 132 in the channel layer 131. As can be seen from FIG. 2a, the electron concentration in the channel layer 131 near the junction 132 is bell shaped, which essentially corresponds to the distribution of the electron concentration in the two-dimensional electron gas area 132G More specifically, the sheet electron concentration in the channel layer 131 is $1.1*10^{13}$ $ns*cm^{-2}$ at a distance of 15 nm from the junction 132.

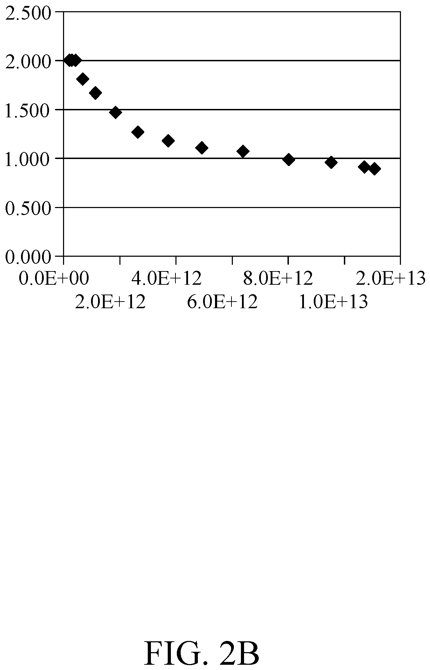

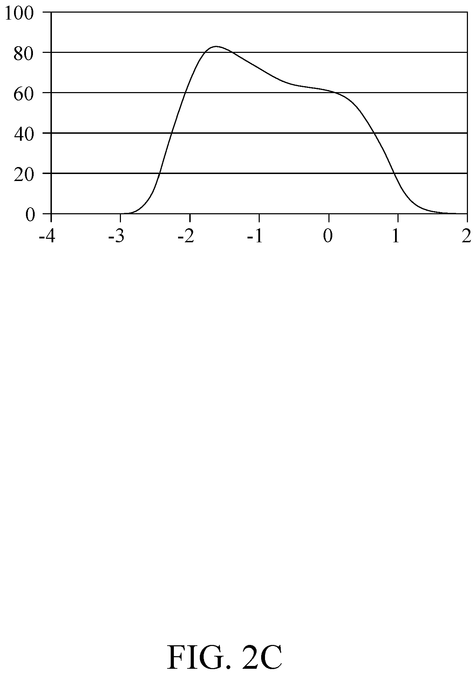

FIG. 2B is a diagram showing the change of electron saturation velocity relative to the number of electrons per unit area according to the conventional semiconductor device 100. The longitudinal axis indicates the electron saturation velocity ($10^7$ cm/s) and the transverse axis indicates the sheet electron concentration ($ns*cm^{-2}$ or $cm^{-2}$). FIG. 2C is a diagram of transconductance ($g_m$) versus gate-source voltage ($V_{gs}$) according to the conventional semiconductor 100 device. The longitudinal axis indicates transconductance (mS) and the transverse axis indicates gate-source voltage (V). As used herein, the term "transconductance" refers to a ratio of the change of source output current to the change of gate-source voltage, which can be used to measure the control ability of the gate-source voltage of a component to the source output current. The unit of transconductance is usually Siemens (S), and the present invention uses millisiemens (mS).

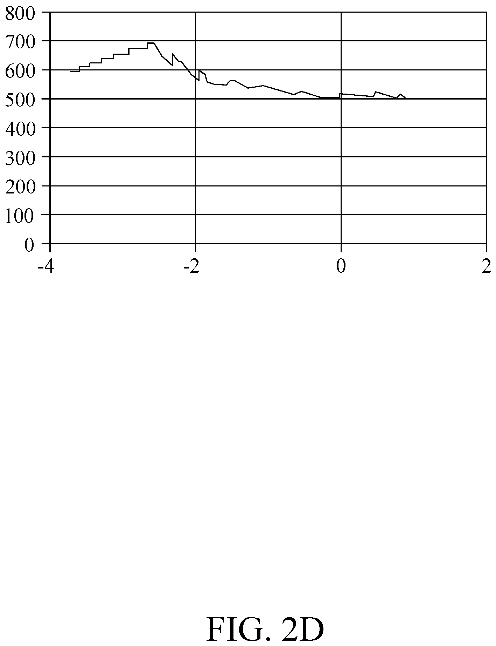

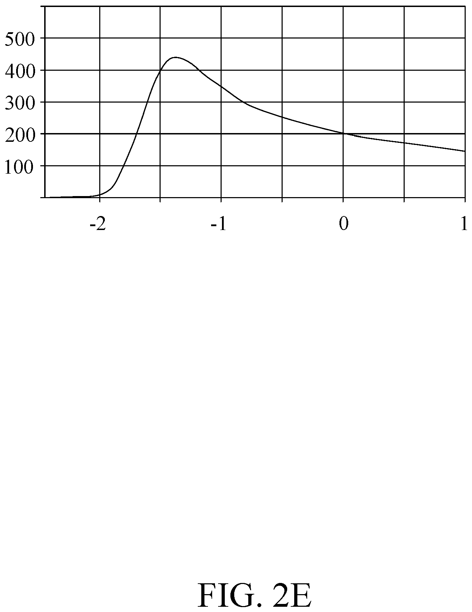

After further analysis, the inventor learned that, without being limited by any specific theory, based on the change of electron saturation velocity relative to sheet electron concentration (as shown in FIG. 2B), the change relationship of transconductance versus gate-source voltage (as shown in FIG. 2C) can be deduced from the distribution of sheet electron concentration relative to space (as shown in FIG. 2A). In the above example, the conventional semiconductor device 100 exhibits at least one prominent peak of transconductance (as shown in FIG. 2C) in the variation of the transconductance relative to gate-source voltage under the condition of the spatial distribution of its electron concentration (as shown in FIG. 2A), which means that the linearity of the conventional semiconductor device 100 is insufficient. On the other hand, based on FIGS. 2A and 2B, this embodiment performs a one-dimensional simulation diagram (FIG. 2D) and a test result diagram (FIG. 2E) of the transconductance versus gate-source voltage of the conventional semiconductor device 100. Both of the longitudinal axises in FIGS. 2D and 2E indicate the transconductance value per unit length (mS/mm), and both of the transverse axises in FIGS. 2D and 2E indicate the gate-source voltage (V). It can be seen that the conventional semiconductor device 100 exhibits an uneven numerical pattern in the performance diagram of the transconductance versus gate-source voltage under such electron concentration distribution conditions (as shown in FIG. 2A).

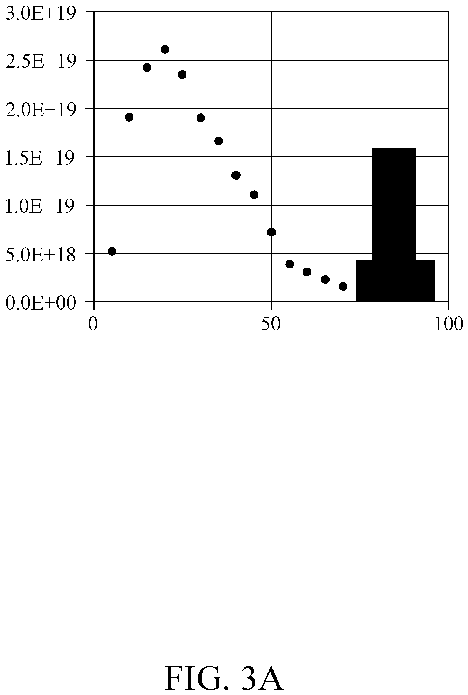

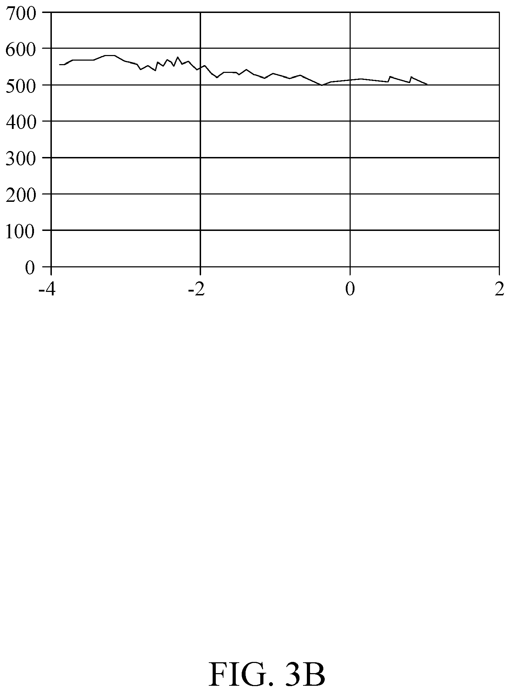

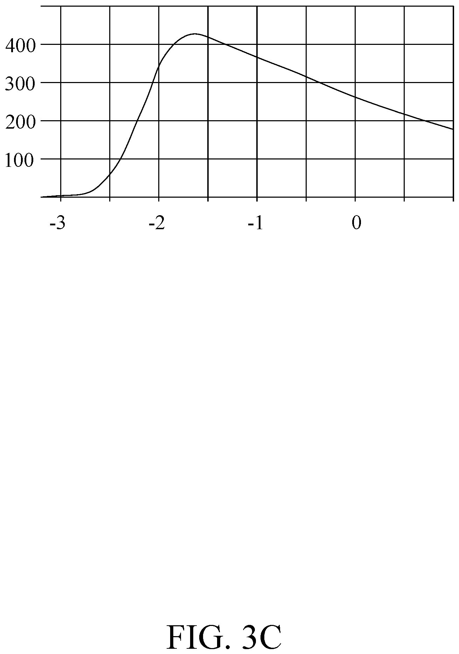

In view of the the above examples, without being limited by any specific theory, the inventor has found that based on the change relationship between electron saturation velocity versus the sheet electron concentration of components, the pattern of transconductance versus gate-source voltage of the component can be derived from the distribution of electron concentration relative to space. The inventor proposes this embodiment accordingly, by implanting an electron group near the boundary of the two-dimensional electron gas area in the transistor channel layer, the electron concentration distribution in the space around the two-dimensional electron gas area in the semiconductor device is adjusted, and the performance of the component in the change of the transconductance versus gate-source voltage is improved, thereby improving the linearity of the transistor. Specifically, this embodiment provides a spatial variation diagram of the electron concentration relative to the channel layer (FIG. 3A), where the longitudinal axis indicates the electron concentration ($ns*cm^{-3}$ or $cm^{-3}$) and the transverse axis indicates a distance (Å or $10^{-1}$ nm) from the junction of the channel layer and the barrier layer. The original sheet electron concentration in the channel layer is $1.1*10^{13}$ $ns*cm^{-2}$ within a distance of 15 nm from the junction. The electron group is implanted in the channel layer at about 6 to 10 nm from the junction, and its sheet electron concentration is $1.92*10^{12}$ ns*cm$^{-2}$. The electron group includes an abruptly rising high concentration electron group with an electron concentration of about $1.5*10^{19}$ ns*cm$^{-3}$. This embodiment also provides a one-dimensional simulation diagram (FIG. 3B) and a test result diagram (FIG. 3C) corresponding to FIG. 3A. The longitudinal axises in FIGS. 3B and 3C indicate the transconductance value per unit length (mS/mm) and the transverse axises in FIGS. 3B and 3C indicate the gate-source voltage (V). As can be seen from FIGS. 3A to 3C, when an electron group is implanted in the transistor channel layer near the boundary of the two-dimensional electron gas area, particularly, when the electron group includes an abruptly rising high concentration electron group, the spatial distribution of the electron concentration in the transistor can be adjusted so that the transconductance of the transistor exhibits a gentle numerical pattern with respect to the change of the gate-source voltage. This performance indicates that the linearity of its transistor is improved.

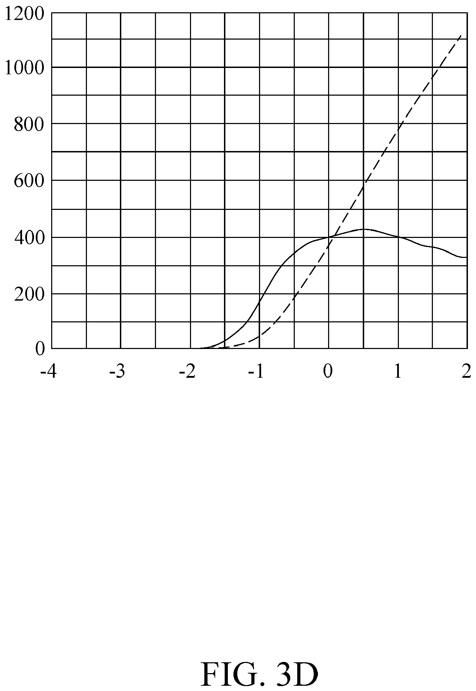

According to various embodiments, an increase in the sheet electron concentration of the implanted electron group also helps to make the transconductance of the transistor show a gentler numerical pattern relative to the change of the gate-source voltage. Specifically, according to one embodiment of the present invention, the sheet electron concentration of said implanted electron group is $4.0*10^{12}$ ns*cm$^{-2}$, that is, twice the concentration used in the above embodiment, and the high concentration electron group contained therein has an electron concentration of $3*10^{19}$ ns*cm$^{-3}$ under a similar distribution pattern. FIG. 3D is a graph showing the test results of the transconductance versus gate-source voltage accordingly, with the longitudinal axis indicates the transconductance value per unit length (mS/mm) shown by a solid line and the drain-source current value (mA/mm) shown by a dashed line, while the transverse axis indicates the gate-source voltage (V). As can be seen from FIG. 3D, by implanting higher electron concentration groups, the spatial distribution of electron concentration in the transistor is further regulated, and the transistor has even better linearity.

According to different embodiments, the sheet electron concentration of the implanted electron group can still reach $6.0*10^{12}$ ns*cm$^{-2}$, and the specific concentration value can be adjusted by a person with common knowledge in the field to which the present application pertains according to the specific parameters of the component. However, the concentration value preferably ranges from $1.5*10^{12}$ to $6*10^{12}$ ns*cm$^{-2}$.

Without affecting the sheet electron concentration of the electron group, the size of the distribution area of the high concentration electron group contained in the range can be adjusted according to the user's requirements. According to one embodiment of the present invention, the high-concentration electron group presents a peak with a width, and the specific distribution area (width) is less than or equal to 3 nm. Preferably, the distribution area (width) is 1 to 3 nm, for example, 1.0, 1.5, 2.0, 2.5 or 3.0 nm.

In view of the above embodiments, the inventor of the present invention has learned that by implanting electron groups around the boundary of the two-dimensional electron gas area, the electron concentration distribution in the transistor having the two-dimensional electron gas area can be effectively adjusted, thereby improving the linearity of the transistor. It should be understood that, according to the difference of transistor itself in material or structural characteristics, the person with general knowledge in the field to which the present invention pertains can adjust the sheet electron concentration or the implantation position of the implanted electron group according to the change of the electron saturation velocity relative to the sheet electron concentration of individual components, the sheet electron concentration of two-dimensional electron gas area or the size of its distribution area and other factors. The detailed definitions may be modified by those skilled in the art to the extent consistent with the spirit of the present invention, and should not be construed to exceed the scope of the present invention.

In detail, the electron group is disposed at about 6 to 10 nm, preferably 6.5 to 8.0 nm, such as 6.5, 6.6, 6.7, 6.8, 6.9, 7.0, 7.1, 7.2, 7.3, 7.4, 7.5, 7.6, 7.7, 7.8, 7.9, 8.0 nm, relative to the junction of the channel layer and barrier layer.

Under the same concept, those who have general knowledge in the field to which the present invention pertains can also change the carrier of the above embodiments from electrons to electron holes according to requirements. Therefore, the user can reasonably change the implanted electron group into a electron hole group.

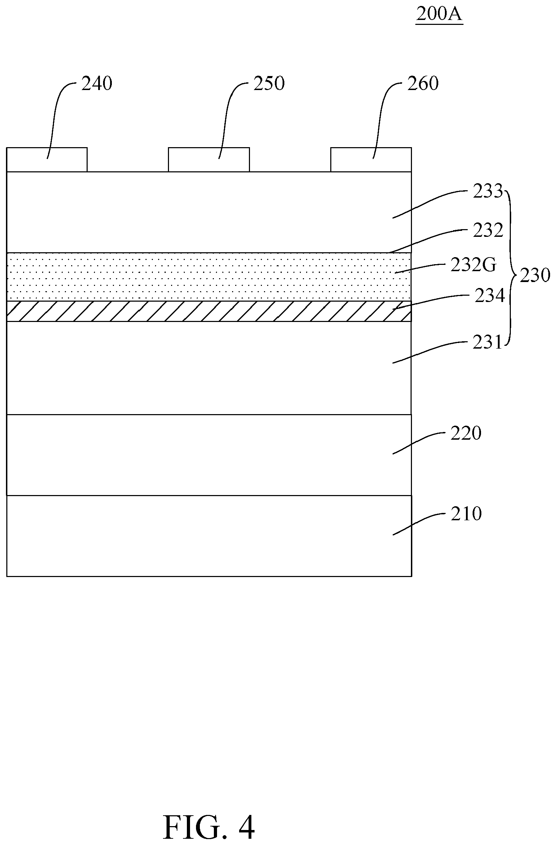

Further, the present invention proposes yet another embodiment of a semiconductor device including a transistor applying the above concepts. FIG. 4 is a cross-sectional view of layered structure presented in accordance with this embodiment. Referring to FIG. 4, this embodiment provides a semiconductor device 200A, which may be a GaN-based semiconductor device and includes a GaN-based compound semiconductor field-effect transistor. However, other suitable monocrystalline silicon compound semiconductor materials can also be used herein. The semiconductor device 200A can be an epitaxial layered structure, which includes a substrate 210, a buffer layer 220, a channel block 230, a source electrode 240, a gate electrode 250 and a drain electrode 260.

The substrate 210 is insulated and it includes a wafer, for example, the wafer is made of a high quality monocrystalline silicon semiconductor, such as sapphire, GaN, GaAs, silicon crystal, any polymorph of silicon carbide (SiC) (including spiauterite), AIN, InP or similar substrate materials for semiconductors.

The buffer layer 220 is disposed on the surface of the substrate 210 and may have a suitable lattice structure and/or coefficient of thermal expansion to compensate for mismatches between the substrate 210 and other layers. The buffer layer 220 includes a compound semiconductor material, such as undoped, unintentionally doped (UID) or carbon doped (C doped) GaN or AlN, and the compound semiconductor material can be formed into a thin film structure by epitaxial growth or by other thin film forming techniques such as chemical vapor deposition. Parametrically, the buffer layer 220 has a thickness of about 150 to 250 nm, preferably 200 nm.

The channel block 230 is disposed on the surface of the buffer layer 220 and further includes a channel layer 231 and a barrier layer 233. A junction 232 is formed between the channel layer 231 and the barrier layer 233. The channel layer 231 and the barrier layer 233 are made of different materials, so the interface 232 is a heterogeneous material interface so that a two-dimensional electron gas area 232G is formed in the channel layer 231 near the junction 232. The two-dimensional electron gas area 232G can form a conductive channel of free electrons when biased, thereby achieving, for example, the purpose of electrically coupling the source electrode 240 and the drain electrode 260. Specifically, the compound semiconductor material of the channel layer 231 is undoped or unintentionally doped GaN, and the compound semiconductor material of the barrier layer 233 is undoped or unintentionally doped $Al_xGa_{1-x}N$, where x is in the range of about 0.1 to about 1. According to some embodiments, x ranges from 0.15 to 1, and more specifically, x ranges from 0.20 to 0.25, such as 0.20, 0.21, 0.22, 0.23, 0.24 or 0.25. On the other hand, the thickness of the channel layer 231 is in the range of about 150 nm to 500 nm, preferably, within a range from 150 nm to 250 nm. The thickness of the barrier layer 233 is in the range of about 1.5 nm to 25 nm, preferably, within a range from 1.5 nm to 20 nm, and the thickness can be adjusted depending on x.

In particular, an n-type doped layer 234 is provided in the channel layer 231 near the junction 232 (in other words, near the two-dimensional electron gas area 232G), which includes an n-type dopant, preferably, a silicon dopant. Specifically, the n-type doped layer 234 is positioned at a distance from the junction 232 of about 6 to 10 nm, preferably 6.5 to 8.0 nm, such as 6.5, 6.6, 6.7, 6.8, 6.9, 7.0, 7.1, 7.2, 7.3, 7.4, 7.5, 7.6, 7.7, 7.8, 7.9, 8.0 nm. On the other hand, the n-type doped layer 234 has a sheet electron concentration in a range from $1.5*10^{12}$ to $6*10^{12}$ ns*cm$^{-2}$, for example: $1.5*10^{12}$, $2*10^{12}$, $2.5*10^{12}$, $3*10^{12}$, $3.5*10^{12}$, $4*10^{12}$, $4.5*10^{12}$, $5*10^{12}$, $5.5*10^{12}$ or $6*10^{12}$ ns*cm$^{-2}$. The n-type doped layer includes a high concentration electron group with an electron concentration of $1.5*10^{19}$ to $3*10^{19}$ ns*cm$^{-3}$, such as $1.5*10^{19}$ ns*cm$^{-3}$, $2*10^{19}$ ns*cm$^{-3}$, $2.5*10^{19}$ ns*cm$^{-3}$ or $3*10^{19}$ ns*cm$^{-3}$.

Under the same concept, those who have general knowledge in the field to which the present invention pertains can also change the carrier of the above embodiments from electrons to electron holes according to requirements. Therefore, the user can reasonably change the n-type doped layer described above into the p-type doped layer.

The gate electrode 250 is disposed on the barrier layer 233, and the source electrode 240 and the drain electrode 260 are disposed near two ends of the gate electrode 250. Specifically, the gate electrode 250 may be any conductive material capable of biasing or controlling the semiconductor device 200A, and may preferably be nickel (Ni)/gold (Au) or zirconium (Zr)/gold (Au) in consideration of generating a larger valence band energy gap with the compound semiconductor material used in the present invention. The source electrode 240 and the drain electrode 260 may be any suitable conductive material capable of forming an ohmic contact or other conductive junction with the two-dimensional electron gas area 232G, preferably, titanium (Ti)/aluminum (Al)/nickel (Ni)/gold (Au). More preferably, in addition to nickel, a refractory metal such as tantalum (Ta) or molybdenum (Mo) can also be used as a diffusion barrier between aluminum and gold.

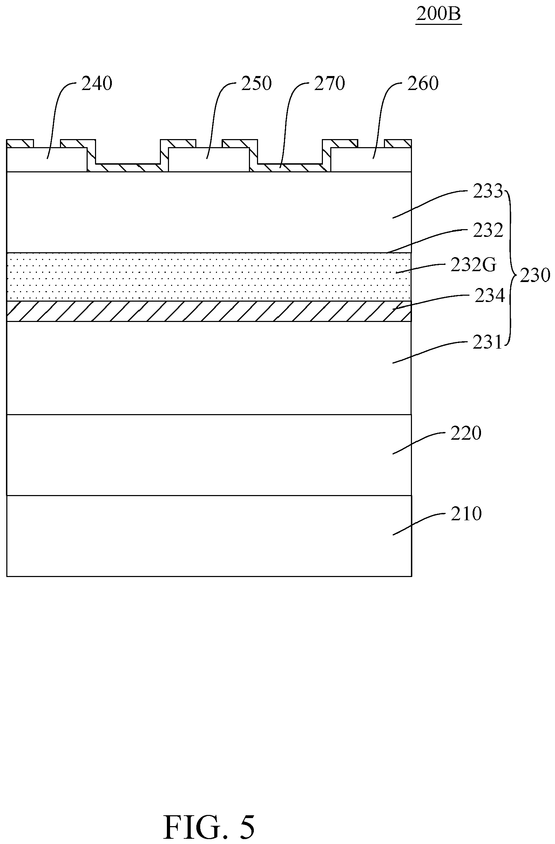

FIG. 5 is a cross-sectional view of the layered structure of a semiconductor device 200B according to an embodiment of the present invention. Both of FIGS. 4 and 5 present similar structures and can respectively be a GaN-based semiconductor device including a GaN-based compound semiconductor field-effect transistor. The difference is that the semiconductor device 200B is further provided with a passivation layer 270 on the barrier layer 233, and the passivation layer 270 covers at least part of the upper surfaces of the source electrode 240, the gate electrode 250 and the drain electrode 260. The passivation layer 270 may also be a gate oxide layer or a silicon nitride ($Si_3N_4$) material.

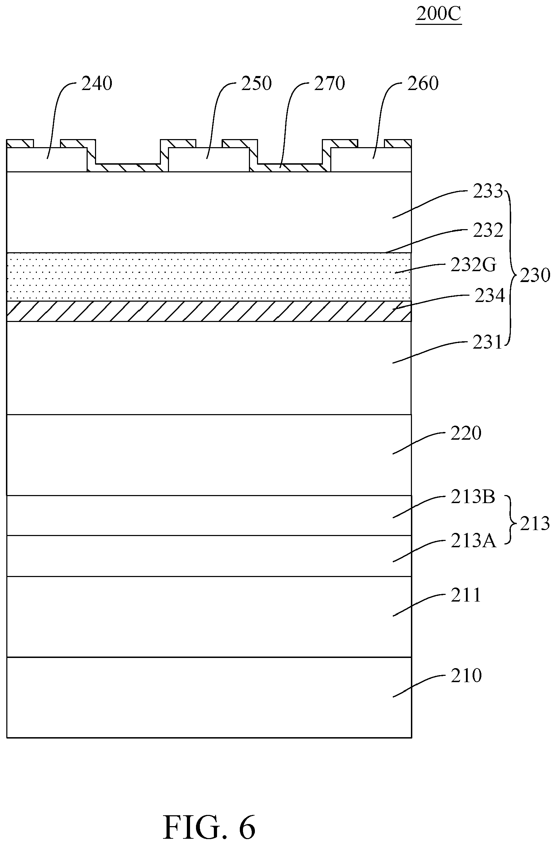

FIG. 6 is a cross-sectional view of the layered structure of a semiconductor device 200C according to an embodiment of the present invention. both of FIGS. 5 and 6 present similar structures and can respectively be a GaN-based semiconductor device including a GaN-based compound semiconductor field-effect transistor. The difference is that the semiconductor device 200C further includes a superlattice layer 213 and a nucleation layer 211, which are formed between the substrate 110 and the buffer layer 120. As used herein, the superlattice layer refers to a lattice layer including a lattice whose periodic structure is longer than the basic unit lattice by superimposing a plurality of lattices.

Specifically, the superlattice layer 213 further includes a first superlattice sublayer 213A and a second superlattice sublayer 213B. The first superlattice sublayer 213A includes undoped or unintentionally doped AlN having a thickness of about 4 to 5 nm, preferably, 4.5 nm. The second superlattice sublayer 213B includes undoped or unintentionally doped GaN having a thickness of about 10 to 30 nm, preferably, 20 nm. The superlattice layer 213 has about 40 periods, so its total thickness is within a range from about 560 to 1400 nm, preferably, 980 nm. On the other hand, the nucleation layer 211 includes an undoped or unintentionally doped AlN compound and has a thickness of about 100 nm.

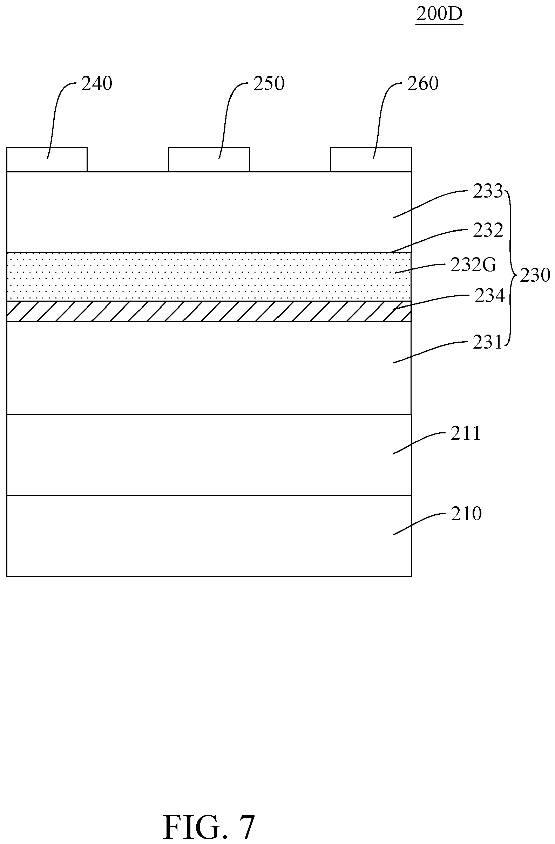

FIG. 7 is a cross-sectional view of the layered structure of a semiconductor device 200D according to an embodiment of the present invention. This embodiment is basically similar to the semiconductor devices 200A to 200C, all the structures can respectively be a GaN-based semiconductor device and include a GaN-based compound semiconductor field-effect transistor. The difference is that the semiconductor device 200D of this embodiment is provided with merely the nucleation layer 211 without the buffer layer 220 between the channel block 230 and the substrate 210. The semiconductor device 200D manufactured based on the setting conditions of this embodiment may have higher collapse voltage and power density, and may effectively reduce thermal resistance, current collapse and memory effect.

According to some embodiments of the present invention, a cap layer containing undoped or unintentionally doped compound semiconductor material, preferably, undoped or unintentionally doped GaN, may be further provided on the barrier layer 233 of the semiconductor device.

In addition, those having general knowledge in the field to which the present invention pertains should be able to apply the concepts of the present invention to other transistors that also generate electron group distribution internally. Specifically, the semiconductor device to which the transistor of the present invention is applied may also be a silicon-based metal oxide semiconductor field-effect transistor (Si-MOSFET) or a silicon carbide-based metal oxide semiconductor field-effect transistor (SiC-MOSFET). In other words, the layered structure of the above embodiments may be whole as a silicon or a silicon carbide substrate, which, when biased at the gate, attracts charges under the barrier layer to create a charge channel, which is referred to as the channel layer. However, it should be understood that, according to the difference of transistor itself in material or structural characteristics, the person with general knowledge in the field to which the present invention pertains can adjust the sheet electron concentration or the setting position of the n-type doped layer according to the change of the electron saturation velocity relative to the sheet electron concentration of individual components, the sheet electron concentration of two-dimensional electron gas area or the size of its distribution area and other factors. The detailed definitions may be modified by those skilled in the art to the extent consistent with the spirit of the present invention, and should not be construed to exceed the scope of the present invention.

**Manufacturing method**

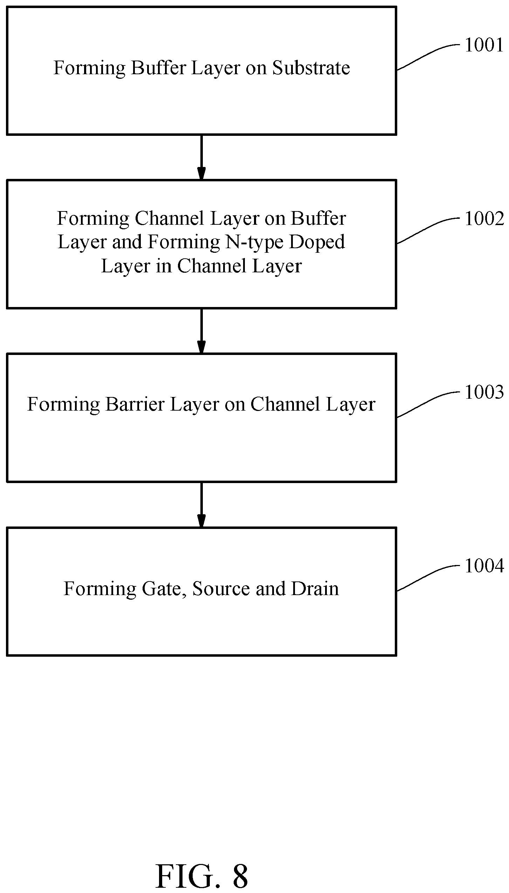

FIG. 8 is a flowchart of manufacturing a semiconductor field-effect transistor in accordance with various embodiments of the present invention. Referring to FIG. 8, manufacturing a semiconductor field-effect transistor according to an embodiment of the present invention includes the following steps: step 1001: forming a buffer layer on a substrate; step 1002: forming a channel layer on the buffer layer and forming an n-type doped layer in the channel layer; step 1003: forming a barrier layer on the channel layer; and step 1004: forming a source, a gate, and a drain. In particular, the steps in the method described herein are only illustratively described according to the concept of the inventor, and it is common knowledge in the art that the present inventor can slightly replace the contents of the above method or even adjust the order of the above steps based on the same or similar concept. Such replacement or adjustment still falls within the scope of the concept of the present invention.

The "appropriate epitaxial growth or deposition process" described in the present invention includes, but is not limited to, chemical vapor deposition (CVD), low pressure chemical vapor deposition (LPCVD), atmospheric pressure chemical vapor deposition (APCVD), ultrahigh vacuum chemical vapor deposition (UHVCVD), atomic layer deposition (ALD), molecular layer deposition (MLD), plasma enhanced chemical vapor deposition (PECVD), metal-organic chemical vapor deposition (MOCVD), molecular beam epitaxy (MBE), sputtering, or a combination thereof.

At step 1001, the substrate may be formed at a preparatory manufacturing process or may be manufactured on the basis of one or more substrate growth and processing techniques. the substrate comprises wafers, such as wafers made of a high quality monocrystalline silicon semiconductor, such as sapphire, GaN, GaAs, silicon crystal, any polymorph of silicon carbide (SiC) (including spiauterite), AlN, InP or similar substrate materials for semiconductors. The buffer layer includes a compound semiconductor material such as undoped, unintentionally doped or carbon doped GaN. The buffer layer is a thin film formed by an appropriate epitaxial growth or deposition process and has a thickness of about 150 to 250 nm, preferably, 200 nm.

According to various embodiments, a nucleation layer and a superlattice layer may be formed on the substrate at step 1001 by an appropriate epitaxial growth or deposition process. The nucleation layer is formed by undoped or unintentionally doped AlN compounds with a thickness of about 100 nm. Forming the superlattice layer further includes forming a first superlattice sublayer and forming a second superlattice sublayer. The first superlattice sublayer is made of undoped or unintentionally doped AlN with a thickness of about 4 to 5 nm, preferably 4.5 nm. The second superlattice sublayer is made of undoped or unintentionally doped GaN having a thickness of about 10 to 30 nm, preferably 20 nm. The superlattice layer is formed at about 40 periods, resulting in a total thickness of about 560 to 1400 nm, preferably 980 nm.

At step 1002, the channel layer is formed of undoped or unintentionally doped GaN by an appropriate epitaxial growth or deposition process. The channel layer has a thickness in the range of about 150 to 500 nm, preferably 150 to 400 nm. The n-type doped layer can be doped, as a dopant, in the channel layer by an appropriate epitaxial growth or deposition process, and the dopant is a silicon dopant. Specifically, the dopant may be implanted during the formation of the channel layer. The n-type doped layer has an sheet electron concentration in a range from $1.5*10^{12}$ to $6*10^{12}$ns*cm$^{-2}$, for example: $1.5*10^{12}$, $2*10^{12}$, $2.5*10^{12}$, $3*10^{12}$, $3.5*10^{12}$, $4*10^{12}$, $4.5*10^{12}$, $5*10^{12}$, $5.5*10^{12}$ or $6*10^{12}$ ns*cm$^{-2}$. The n-type doped layer includes a high concentration electron group with an electron concentration of $1.5*10^{19}$ to $3*10^{19}$ ns*cm$^{-3}$, such as $1.5*10^{19}$ ns*cm$^{-3}$, $2*10^{19}$ ns*cm$^{-3}$, $2.5*10^{19}$ ns*cm$^{-3}$ or $3*10^{19}$ ns*cm$^{-3}$.

Under the same concept, those who have general knowledge in the field to which the present invention pertains can also change the carrier of the above embodiments from electrons to electron holes according to requirements. Therefore, the user can reasonably change the n-type doped layer into the p-type doped layer and implant the p-type dopant accordingly.

At step 1003, the barrier layer is formed of undoped or unintentionally doped Al$_x$Ga$_{1-x}$N, where x is in the range of about 0.1 to about 1. According to some embodiments, x is in a range from 0.15 to 1, and according to different embodiments, x is in a range from 0.20 to 0.25, and the barrier layer is manufactured by an appropriate epitaxial growth or deposition process. The thickness of the barrier layer is in the range of about 5 to 20 nm, preferably 10 to 15 nm.

Step 1004 may include a preparatory procedure, such as mesa isolation fabrication, which further includes an etching process or the like as required. The etching process may be dry etching or wet etching, preferably dry etching such as Reactive Ion Etching (RIE), Inductively Coupled Plasma (ICP) etching and other physical bombardments. Next, the gate may be made of any conductive material capable of biasing or controlling the semiconductor device, preferably nickel (Ni)/gold (Au) or zirconium (Zr)/gold (Au), and formed on the p-type material layer by an appropriate epitaxial growth or deposition process. The source and drain can be made of any suitable conductive material capable of forming an ohmic contact or other conductive junction, preferably using titanium (Ti)/aluminum (Al)/nickel (Ni)/tantalum (Ta)/molybdenum (Mo)/gold (Au) and formed near two ends of the gate by an appropriate epitaxial growth or deposition process. In addition, in some embodiments, step 1004 may further include a passivation process that provides a passivation layer, which may be formed by an appropriate epitaxial growth or deposition process and covers at least part of upper surfaces of the source, gate, and drain. The passivation layer can also be a gate oxide layer or be formed of silicon nitride (Si$_3$N$_4$) material.

In the manufacturing method, the n-type doped layer is formed at a distance of about 6 to 10 nm, preferably 6.5 to 8.0 nm, such as 6.5, 6.6, 6.7, 6.8, 6.9, 7.0, 7.1, 7.2, 7.3, 7.4, 7.5, 7.6, 7.7, 7.8, 7.9, 8.0 nm, from the junction of the channel layer and the barrier layer.

To sum up, the technical problem to be solved by the present invention in comparison with the prior arts is that, based on the discovery of the correlation between the spatial electron concentration distribution around the two-dimensional electron gas area in a transistor and device linearity, the channel layer of the semiconductor field effect transistor provided by the present invention is provided with an n-type doped layer with a specific sheet electron concentration at the boundary of the two-dimensional electron gas area. The n-type doped layer is used to change the electron concentration distribution in the space around the two-dimensional electron gas area in the transistor, thereby improving the linearity of the whole component.

The present invention has been described in detail above, but the above-mentioned is only a preferred embodiment of the present invention, so the scope of implementation of the present invention cannot be limited by this, that is, all equivalent changes and modifications made in accordance with the scope of application for patent of the present invention should still be covered by the patent of the present invention.

**Claims**

1. A semiconductor field-effect transistor comprising:

   a channel layer (231);
   a barrier layer (233) disposed on the channel layer;
   a gate (250) disposed on the barrier layer (233); and
   a source (240) and a drain (260) disposed near two ends of the gate, respectively;
   wherein the channel layer (231) and the barrier layer (233) comprises different materials, and the channel layer (231) is provided with a two-dimensional electron gas area (232G) near the barrier layer;
   wherein the channel layer further comprises an n-type doped layer (234) disposed at a boundary of the two-dimensional electron gas area (232G).

2. The semiconductor field-effect transistor according to claim 1, wherein the n-type doped layer (232G) comprises a silicon dopant.

3. The semiconductor field-effect transistor according to claim 1 or 2, wherein the n-type doped layer (232G) has a sheet electron concentration between $1.5*10^{12}$ and $6*10^{12}$ ns*cm$^{-2}$; and the n-type doped layer (232G) comprises a high concentration electron group with an electron concentration of $1.5*10^{19}$ to $3*10^{19}$ ns*cm$^{-3}$.

**4.** The semiconductor field-effect transistor according to any of the preceding claims, wherein the n-type doped layer (232G) is separated from a junction of the channel layer and the barrier layer by a distance in the range between 6 to 10 nm.

**5.** The semiconductor field-effect transistor according to any of the preceding claims, wherein the channel layer (231) is formed by unintentionally doped or undoped GaN, and the barrier layer (233) is formed by unintentionally doped or undoped AlGaN.

**6.** The semiconductor field-effect transistor according to any of the preceding claims, further comprising a passivation layer (270) disposed on the barrier layer (233), the passivation layer covering at least part of upper surfaces of the source, the gate and the drain.

**7.** The semiconductor field-effect transistor according to any of the preceding claims, further comprising a buffer layer (120) disposed below the channel layer (233).

**8.** The semiconductor field-effect transistor according to any of the preceding claims, wherein the semiconductor field-effect transistor is a Modulation-Doped Field-Effect Transistor (MODFET), a High Electron Mobility Transistor (HEMT), a Metal-Oxide-Semiconductor Field-Effect Transistor (MOSFET), a Metal-Semiconductor Field-Effect Transistor (MESFET) or a Metal-Insulator-Semiconductor Field-Effect Transistor (MISFET).

**9.** A power amplifier comprising the semiconductor field-effect transistor according to any of claims 1 to 8.

**10.** A method of manufacturing a semiconductor field-effect transistor, in particular the semiconductor field-effect transistor as claimed in any of claims 1 to 8, comprising:

forming a buffer layer on a substrate (1001);
forming a channel layer on the buffer layer and forming an n-type doped layer in the channel layer (1002);
forming a barrier layer on the channel layer; and forming a gate on the barrier layer (1003); and forming a source and a drain near two ends of the gate electrode, respectively (1004).

**11.** The method of manufacturing the semiconductor field-effect transistor according to claim 10, wherein the n-type doped layer is formed by doping a silicon dopant.

**12.** The method of manufacturing the semiconductor field-effect transistor according to claim 10 or 11, wherein the n-type doped layer is formed to have a sheet electron concentration between $1.5*10^{12}$ and $6*10^{12}$ ns*cm$^{-2}$; and the n-type doped layer comprises a high concentration electron group with an electron concentration of $1.5*10^{19}$ to $3*10^{19}$ ns*cm$^{-3}$.

**13.** The method of manufacturing the semiconductor field-effect transistor according to claim 10 or 11, wherein the n-type doped layer is formed at a distance in the range between 6 and 10 nm from a junction of the channel layer and the barrier layer.

FIG. 1

FIG. 2A

FIG. 2B

FIG. 2C

FIG. 2D

FIG. 2E

FIG. 3A

FIG. 3B

FIG. 3C

FIG. 3D

200A

240    250    260

233
232
232G
234
231

230

220

210

FIG. 4

FIG. 5

200C

240        250   270   260

233 ⎫
232 ⎪
232G ⎬ 230
234 ⎪
231 ⎭

220

213B ⎫
      ⎬ 213
213A ⎭

211

210

FIG. 6

200D

240  250  260

233
232
232G
234
231
230

211

210

FIG. 7

```
┌─────────────────────────────────────┐
│                                     │
│   Forming Buffer Layer on Substrate │ ⎯ 1001
│                                     │
└─────────────────────────────────────┘
                 │
                 ▼
┌─────────────────────────────────────┐
│   Forming Channel Layer on Buffer   │
│   Layer and Forming N-type Doped    │ ⎯ 1002
│       Layer in Channel Layer        │
└─────────────────────────────────────┘
                 │
                 ▼
┌─────────────────────────────────────┐
│                                     │
│  Forming Barrier Layer on Channel Layer │ ⎯ 1003
│                                     │
└─────────────────────────────────────┘
                 │
                 ▼
┌─────────────────────────────────────┐
│                                     │
│   Forming Gate, Source and Drain    │ ⎯ 1004
│                                     │
└─────────────────────────────────────┘
```

FIG. 8

Europäisches
Patentamt

European
Patent Office

Office européen
des brevets

# EUROPEAN SEARCH REPORT

Application Number

EP 23 15 4694

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 9 231 064 B1 (REZA SHAHED [US] ET AL) 5 January 2016 (2016-01-05) * figure 1 and associated text * ----- | 1-13 | INV. H01L29/778 H01L29/36 |
| X | INOUE KAZUTAKA ET AL: "Linearity Improvement of GaN HEMT for Wireless Communication Applications", SEI TECHNICAL REVIEW, no. 78, April 2014 (2014-04), pages 48-52, XP093055429, * figure 12 and associated text * ----- | 1-13 | ADD. H01L29/20 |
| X | US 5 262 660 A (STREIT DWIGHT C [US] ET AL) 16 November 1993 (1993-11-16) * figure 1 and associated text * ----- | 1-4,6-13 | |

TECHNICAL FIELDS SEARCHED (IPC)

H01L

The present search report has been drawn up for all claims

| Place of search | Date of completion of the search | Examiner |
|---|---|---|
| Munich | 20 July 2023 | Moehl, Sebastian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 15 4694

This annex lists the patent family members relating to the patent documents cited in the above-mentioned European search report.
The members are as contained in the European Patent Office EDP file on
The European Patent Office is in no way liable for these particulars which are merely given for the purpose of information.

20-07-2023

| Patent document cited in search report | | Publication date | Patent family member(s) | | Publication date |
|---|---|---|---|---|---|
| US 9231064 | B1 | 05-01-2016 | EP | 3195365 A1 | 26-07-2017 |
| | | | TW | 201611271 A | 16-03-2016 |
| | | | US | 9231064 B1 | 05-01-2016 |
| | | | WO | 2016025043 A1 | 18-02-2016 |
| US 5262660 | A | 16-11-1993 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Sheet Carrier Concentration and Threshold Voltage Modeling of Asymmetrically Doped AlGaN/GaN/Al-GaN Double Heterostructure HEMT. **NISHA CHUGH ; MONIKA BHATTACHARYA ; MANOJ KUMAR ; R.S GUPTA.** 2017 4th IEEE Uttar Pradesh Section International Conference on Electrical, Computer and Electronics (UPCON). GLA University, 26 October 2017, 446-451

- **BERNARD GIL.** Stress Effects on Optical Properties. 1999, vol. 57, 209-274